# EUROPEAN PATENT APPLICATION

(11) **EP 4 669 056 A2**
(43) Date of publication of application: **24.12.2025**
(21) Application number: 25183995.7
(22) Date of filing: 19.06.2025
(51) Int. Cl.: H10D 86/40, H10K 59/131

(54) **DISPLAY DEVICE AND ELECTRONIC DEVICE INCLUDING THE SAME**

(30) Priority: 19.06.2024 KR 20240079811; 17.12.2024 KR 20240188921
(71) Applicant: Samsung Display Co., Ltd., Yongin-si, Gyeonggi-do 17113 (KR)
(72) Inventor: PARK, Hyun Ae, 17113 Yongin-si (KR); KIM, Dae Hyun, 17113 Yongin-si (KR); KIM, Sung Hwan, 17113 Yongin-si (KR); SHIN, Hey Jin, 17113 Yongin-si (KR); JIN, Chang Kyu, 17113 Yongin-si (KR)
(74) Representative: Taor, Simon Edward William

(57) **Abstract**

According to embodiments of the disclosure, a display device includes a display panel including a sub-pixel and a driver to control the display panel. The display panel includes a first conductive layer including a first portion overlapping a first portion of a first active layer, the first active layer disposed over the first conductive layer, an initialization voltage being applied to the first portion of the first active layer, a second portion of the first active layer forming a channel region of at least one transistor of the sub-pixel, a second conductive layer disposed over the first active layer and including a first conductive pattern forming a control electrode of the at least one transistor, and a third conductive layer disposed over the second conductive layer and including a second conductive pattern forming a horizontal bridge line and overlapping the first portion of the first active layer.

## Description

### CROSS-REFERENCE TO RELATED APPLICATION

The present application claims priority under 35 U.S.C. § 119(a) to Korean Patent Application Nos. 10-2024-0079811, filed on June 19, 2024, and 10-2024-0188921, filed on December 17, 2024, in the Korean Intellectual Property Office.

### BACKGROUND

### 1. TECHNICAL FIELD

The present disclosure generally relates to a display device and an electronic device including the same. More specifically, the present disclosure relates to a display device including a bridge line and an electronic device including the same.

### 2. RELATED ART

As information technology develops, importance of a display device, which is a connection medium between a user and information, is emerging. Accordingly, the use of display devices such as liquid crystal display devices and organic light-emitting display devices is increasing.

### SUMMARY

Embodiments are to provide a display device that minimizes unintentionally formed stains caused by a transistor and an electronic device including the same.

A display device according to embodiments includes a display panel including a sub-pixel, and a driver to control the display panel. The display panel includes a first conductive layer including a first portion overlapping a first portion of a first active layer, the first active layer disposed over the first conductive layer, an initialization voltage being applied to the first portion of the first active layer, a second portion of the first active layer forming a channel region of at least one transistor of the sub-pixel, a second conductive layer disposed over the first active layer and including a first conductive pattern forming a control electrode of the at least one transistor, and a third conductive layer disposed over the second conductive layer and including a second conductive pattern forming a horizontal bridge line and overlapping the first portion of the first active layer.

In an embodiment, a first power supply voltage may be applied to the first conductive layer.

In an embodiment, the display panel may further include a second active layer including a portion forming a channel region of a driving transistor of the sub-pixel, and the first conductive layer may include a second portion overlapping the portion of the second active layer.

In an embodiment, the first portion of the first active layer may not overlap the first conductive pattern.

In an embodiment, the second portion of the first active layer may overlap the first conductive pattern.

In an embodiment, the display panel may further include a display area including sub-pixels including the sub-pixel and a non-display area. The display area may include a first display area and a second display area. At least one of the sub-pixels is in the first display area and may be electrically connected to the driver through a bridge line including a data line and the horizontal bridge line. At least one of the sub-pixels is in the second display area and may be connected to the driver through the data line.

In an embodiment, the bridge line may be connected to the data line via the display area.

In an embodiment, the bridge line may further include a vertical bridge line extending in one direction. The horizontal bridge line may extend in a direction intersecting the one direction.

In an embodiment, the display panel may include a fourth conductive layer disposed over the third conductive layer and including a conductive pattern forming the vertical bridge line.

In an embodiment, the sub-pixel may include a driving transistor, a storage capacitor connected to a control electrode of the driving transistor, and an initialization transistor to provide the initialization voltage to the storage capacitor in response to an initialization gate signal. The second portion of the first active layer may form a channel region of the initialization transistor.

In an embodiment, the display panel may further include a second active layer disposed over the first conductive layer and disposed under the first active layer, a fifth conductive layer disposed over the second active layer and disposed under the first active layer, and a sixth conductive layer disposed over the fifth conductive layer and disposed under the first active layer.

A display device according to embodiments includes a display panel including a sub-pixel, and a driver to control the display panel. The display panel includes a first active layer including a first portion to receive an initialization voltage and a second portion forming a channel region of at least one transistor of the sub-pixel, a second conductive layer disposed over the first active layer and including a first conductive pattern forming a control electrode of the at least one transistor, and a third conductive layer disposed over the second conductive layer and including a second conductive pattern forming a horizontal bridge line and does not overlap a boundary region between the first portion of the first active layer and the second portion of the first active layer.

In an embodiment, the second conductive pattern may include first portions extending in one direction and second portions extending from the first portions in a direction intersecting the one direction to connect the first portions.

In an embodiment, the first portion of the first active layer may not overlap the first conductive pattern.

In an embodiment, the second portion of the first active layer may overlap the first conductive pattern.

In an embodiment, the display panel may further include a display area including sub-pixels including the sub-pixel and a non-display area. The display area may include a first display area and a second display area. At least one of the sub-pixels is in the first display area and is electrically connected to the driver through a data line and a bridge line including the horizontal bridge line. At least one of the sub-pixels is in the second display area and may be connected to the driver through the data line.

In an embodiment, the bridge line may be connected to the data line via the display area.

In an embodiment, the bridge line may further include a vertical bridge line extending in one direction. The second conductive pattern may include first portions extending in a direction intersecting the one direction.

In an embodiment, the display panel may further include a fourth conductive layer disposed over the third conductive layer and including a conductive pattern forming the vertical bridge line.

An electronic device according to embodiments includes a processor to provide input image data, and a display device to display an image based on the input image data. The display device includes a display panel including a sub-pixel, and a driver to control the display panel. The display panel includes a first conductive layer including a first portion overlapping a first portion of a first active layer, the first active layer disposed over the first conductive layer, an initialization voltage being applied to the first portion of the first active layer, a second portion of the first active layer forming a channel region of at least one transistor of the sub-pixel, a second conductive layer disposed over the first active layer and including a first conductive pattern forming a control electrode of the at least one transistor, and a third conductive layer disposed over the second conductive layer and including a second conductive pattern forming a horizontal bridge line and overlapping the first portion of the first active layer.

According to an aspect, there is provided a display device as set out in claim 1. Additional features are set out in claims 2 to 11. According to an aspect, there is provided a display device as set out in claim 12. Additional features are set out in claims 13 and 14. According to an aspect, there is provided an electronic device as set out in claim 15.

### BRIEF DESCRIPTION OF THE DRAWINGS

FIG. 1 is a schematic plan view of a display device according to an embodiment.
FIG. 2 is a schematic plan view of a display device according to an embodiment.
FIG. 3 is a circuit diagram illustrating an example of a sub-pixel of the display device of FIG. 1.
FIG. 4 is an arrangement diagram illustrating an example of a display panel of FIG. 1.
FIG. 5 is an arrangement diagram illustrating a lower conductive layer of FIG. 4.
FIG. 6 is an arrangement diagram illustrating a first active layer of FIG. 4.
FIG. 7 is an arrangement diagram illustrating a first gate conductive layer of FIG. 4.
FIGS. 8 is an arrangement diagram illustrating a second gate conductive layer of FIG. 4.
FIG. 9 is an arrangement diagram illustrating a second active layer of FIG. 4.
FIG. 10 is an arrangement diagram illustrating a third gate conductive layer of FIG. 4.
FIG. 11 is an arrangement diagram illustrating a first upper conductive layer of FIG. 4.
FIG. 12 is an arrangement diagram illustrating a second upper conductive layer of FIG. 4.
FIG. 13 is an arrangement diagram illustrating an anode electrode of FIG. 4.
FIG. 14 is an arrangement diagram illustrating a lower conductive layer of a display device according to embodiments.
FIG. 15 is an arrangement diagram illustrating a first upper conductive layer of a display device according to embodiments.
FIG. 16 is a block diagram of an electronic device according to an embodiment.
FIG. 17 is a schematic diagram of an electronic device according to various embodiments.

### DETAILED DESCRIPTION

Hereinafter, embodiments of the present disclosure will be described in more detail with reference to the accompanying drawings. In the description below, only a necessary part to understand an operation according to the present disclosure is described and the descriptions of other parts are omitted in order not to unnecessarily obscure subject matters of the present disclosure. In addition, the present disclosure is not limited to exemplary embodiments described herein, but may be embodied in various different forms. Rather, exemplary embodiments described herein are provided to thoroughly and completely describe the disclosed contents and to sufficiently transfer the ideas of the disclosure to a person of ordinary skill in the art.

In the entire specification, when an element is referred to as being "connected" or "coupled" to another element, it can be directly connected or coupled to another element or be indirectly connected or coupled to another element with one or more intervening elements interposed therebetween. The technical terms used herein are used only for the purpose of illustrating a specific embodiment and not intended to limit the embodiment. It will be understood that when a component "includes" an element, unless there is another opposite description thereto, it should be understood that the component does not exclude another element but may further include another element. It will be understood that for the purposes of this disclosure, "at least one of X, Y, and Z" can be construed as X only, Y only, Z only, or any combination of two or more items X, Y, and Z (e.g., XYZ, XYY, YZ, ZZ). Similarly, for the purposes of this disclosure, "at least one selected from the group consisting of X, Y, and Z" can be construed as X only, Y only, Z only, or any combination of two or more items X, Y, and Z (e.g., XYZ, XYY, YZ, ZZ).

It will be understood that, although the terms "first", "second," etc. may be used herein to describe various elements, these elements should not be limited by these terms. These terms are only used to distinguish one element from another element. Thus, a "first" element discussed below could also be termed a "second" element without departing from the teachings of the present disclosure.

Spatially relative terms, such as "below," "above," and the like, may be used herein for ease of description to describe the relationship of one element to another element, as illustrated in the figures. It will be understood that the spatially relative terms, as well as the illustrated configurations, are intended to encompass different orientations of the apparatus in use or operation in addition to the orientations described herein and depicted in the figures. For example, if the apparatus in the figures is turned over, elements described as "below" or "beneath" other elements or features would then be oriented "above" the other elements or features. Thus, the exemplary term, "above," may encompass both an orientation of above and below. The apparatus may be otherwise oriented (e.g., rotated 90 degrees or at other orientations) and the spatially relative descriptors used herein interpreted accordingly.

In addition, the embodiments of the disclosure are described here with reference to schematic diagrams of ideal embodiments (and an intermediate structure) of the present disclosure, so that changes in a shape as shown due to, for example, manufacturing technology and/or a tolerance may be expected. Therefore, the embodiments of the present disclosure shall not be limited to the specific shapes of a region shown here, but include shape deviations caused by, for example, the manufacturing technology. The regions shown in the drawings are schematic in nature, and the shapes thereof do not represent the actual shapes of the regions of the device, and do not limit the scope of the disclosure.

Hereinafter, the present disclosure will be described in more detail with reference to the accompanying drawings.

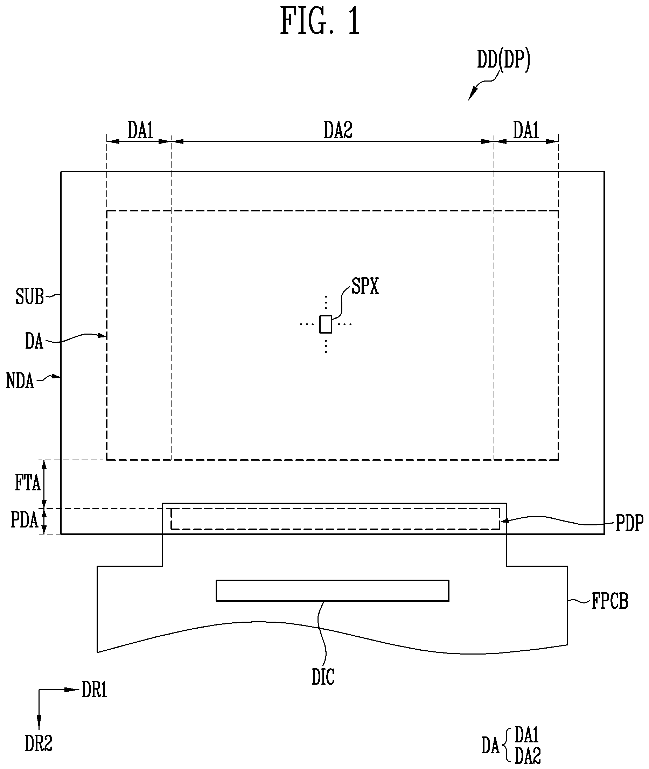

FIG. 1 is a schematic plan view of a display device DD according to an embodiment.

In FIG. 1, for convenience of description, a structure of the display device DD, for example, a display panel DP included in the display device DD, is briefly illustrated around a display area DA in which an image is displayed.

Referring to FIG. 1, the display device DD (or the display panel DP) may include a substrate SUB and sub-pixels SPX.

The display device DD may be provided in various shapes, and for example, may be provided in a rectangular plate shape having two pairs of sides parallel to each other, but is not limited thereto. When the display device DD is provided in an electronic device such as a smartphone, a television, a tablet PC, a mobile phone, a video phone, an e-book reader, a desktop PC, a laptop PC, a netbook computer, a workstation, a server, a personal digital assistant (PDA), a portable multimedia player (PMP), an MP3 player, a medical device, a camera, or a wearable device with a display surface applied to at least one surface, the present embodiment may be applied.

The substrate SUB may include a transparent insulating material to allow transmission of light. The SUB may be a rigid substrate or a flexible substrate.

The rigid substrate may be, for example, one of a glass substrate, a quartz substrate, a glass ceramic substrate, and a crystalline glass substrate.

The flexible substrate may be one of a film substrate including a polymeric organic material and a plastic substrate. For example, the flexible substrate may comprise at least one of polystyrene, polyvinyl alcohol, polymethylmethacrylate, polyether sulfone, polyacrylate, polyetherimide, polyethylene naphtholate, polyethylene terephthalate, polyphenylene sulfide, polyacrylate, polyimide, polycarbonate, triacetate cellulose, and cellulose acetate propionate.

An area of the substrate SUB may be provided as the display area DA to arrange the sub-pixels SPX, and the remaining area of the substrate SUB may be provided as a non-display area NDA.

In an embodiment, the display area DA may include a first area DA1 and a second area DA2. For example, the display area DA may include the second area DA2 located in the center and the first area DA1 disposed over opposite sides with the second area DA2 interposed therebetween. The first area DA1 may be an area located in an outer direction rather than a center direction of the display panel DP around the second area DA2, but is not limited thereto.

The sub-pixels SPX may be disposed in each of the first area DA1 and the second area DA2.

Each of the sub-pixels SPX may include a light-emitting element including a light-emitting layer. According to an embodiment, the light-emitting device may include, but is not limited to, an organic light-emitting diode or an inorganic light-emitting diode having a size in the range of micro to nanoscale (or meter).

The display device DD may display images in the first area DA1 and the second area DA2 by driving the sub-pixels SPX in response to the input image data.

According to an embodiment, the display area DA may include a sensing area capable of sensing a user's fingerprint, or the like. For example, the first area DA1 and the second area DA2 may be set as sensing areas capable of sensing a user's fingerprint, or the like. When the entire display area DA is set as the sensing area, the non-display area NDA surrounding the display area DA may be a non-sensing area.

The non-display area NDA may include a fan-out area FTA and a pad area PDA.

The pad area PDA may be located closer to the edge of the non-display area NDA than the fan-out area FTA.

The fan-out area FTA may be located adjacent to the display area DA in the non-display area NDA. For example, the fan-out area FTA may be an area of the non-display area NDA located between the pad area PDA and the display area DA. According to an embodiment, the non-display area NDA may include an antistatic circuit area in which an antistatic circuit electrically connected to signal lines located in the display area DA to prevent the generation of static electricity is located.

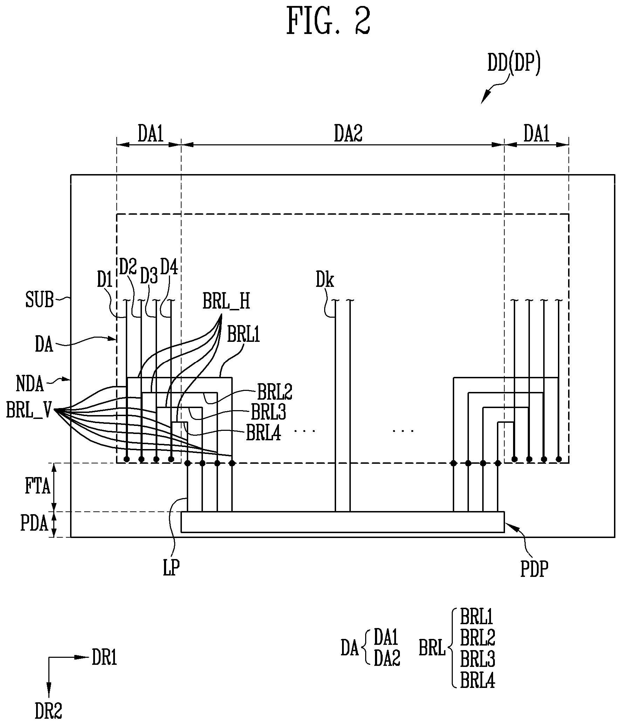

In the fan-out area FTA, a wiring portion LP (refer to FIG. 2) may be located, and in the pad area PDA, a pad portion PDP may be located.

The display device DD may include a circuit board FPCB connected to the display panel DP through the pad portion PDP. The circuit board FPCB may be a flexible circuit board, but is not limited thereto.

The circuit board FPCB may process various signals input from a printed circuit board and output the processed signals to the display panel DP. For this purpose, one end of the circuit board FPCB may be attached to the display panel DP, and another end facing the one end may be attached to the printed circuit board. The circuit board FPCB may be connected to each of the display panel DP and the printed circuit board by a conductive adhesive member (for example, an anisotropic conductive film).

A driver DIC may be mounted on the circuit board FPCB. For example, the driver DIC may be an integrated circuit. The driver DIC may include a panel driver, or the like.

The panel driver may sequentially scan the sub-pixels SPX and supply data voltages corresponding to the image data signals to the sub-pixels SPX. In such a case, the display panel DP may display an image corresponding to the image data. According to an embodiment, the panel driver may supply a driving signal for fingerprint detection to the sub-pixels SPX.

FIG. 2 is a schematic plan view of the display device DD according to an embodiment.

Referring to FIG. 2, the display device DD (or the display panel DP) may include the substrate SUB, the wiring portion LP, and the pad portion PDP.

The pad portion PDP may be located in the pad area PDA of the non-display area NDA, and may be electrically connected to the wiring portion LP.

The wiring portion LP may be located in the fan-out area FTA of the non-display area NDA, and may be electrically connected to the sub-pixels SPX of FIG. 1 to transmit a predetermined signal applied from the driver DIC of FIG. 1 to the signal wirings. The wiring portion LP may include fan-out lines electrically connecting the driver DIC and the sub-pixels SPX in the fan-out area FTA.

In an embodiment, the wiring portion LP may be located in a central portion of the fan-out area FTA corresponding to the second area DA2 of the display area DA. The wiring portion LP may include a first wiring and a second wiring. The first wiring may be electrically connected to data lines Dk located in the second area DA2 of the display area DA through a contact hole. The second wiring may be electrically connected to data lines D1, D2, D3, and D4 located in the first area DA1 of the display area DA through the contact hole and bridge lines BRL.

The substrate SUB may include the display area DA and the non-display area NDA. The display area DA may be divided into the first area DA1 and the second area DA2.

Signal lines to which various signals are applied may be disposed in the first area DA1 and the second area DA2. For example, the data lines D1 to Dk to which a data voltage for adjusting brightness in each of the sub-pixels SPX is applied may be disposed in the first area DA1 and the second area DA2. Various signal lines such as power lines and scan lines other than the data lines D1 to Dk may be disposed in the first area DA1 and the second area DA2.

In the first area DA1 and the second area DA2, the sub-pixel SPX may be disposed or located in an area (for example, a pixel area) partitioned by the scan lines and the data lines (for example, the data lines D1 to Dk). The data lines D1 to Dk may extend in a second direction DR2 in the display area DA. In FIG. 2, the first to fourth data lines D1 to D4 may be located in the first area DA1 (hereinafter referred to as a "1-1 area") adjacent to one side (e.g., the left side) of the second area DA2. In addition, four data lines may be disposed in the first area DA1 (hereinafter referred to as a "1-2 area") adjacent to an opposite side (for example, the right side) of the second area DA2. For convenience of description, the four data lines are being illustrated as disposed in the first area DA1, but embodiments are not limited thereto.

Each of the data lines Dk located in the second area DA2 may be electrically connected to the first wiring. The data lines D1 to D4 located in the first area DA1 may be electrically connected to the bridge line BRL. The bridge line BRL may be arranged to pass through a portion of the display area DA adjacent to the non-display area NDA. For example, the bridge line BRL may include a horizontal bridge line BRL_H extending in a first direction DR1 and a vertical bridge line BRL_V extending in the second direction DR2.

As described above, the area of the non-display area NDA outside the display area DA may effectively be reduced by allowing the input signal (e.g., the data voltage) of the wiring portion LP to be transmitted to the data lines D1 to D4 through the bridge line BRL. The bridge line BRL pass through a portion of the display area DA adjacent to the non-display area NDA, instead of directly connecting the data lines D1 to D4 to the wiring portion LP within a certain area of the display area DA, such as the first area DA. The bridge line BRL may include bridge lines BRL1, BRL2, BRL3, BRL4 that connect the respective data lines D1 to D4 to the wiring portion LP.

The bridge line BRL is briefly illustrated in FIG. 2 for convenience of description, and the horizontal bridge line BRL_H may extend in the first direction DR1 and/or in a direction opposite to the first direction DR1, and the vertical bridge line BRL_V may extend in the second direction DR2 and/or in a direction opposite to the second direction DR2, more than being illustrated. However, when the horizontal bridge line BRL_H and the vertical bridge line BRL_V are further extended, the signal may be transmitted through substantially the same path as shown in FIG. 2 by connection between the horizontal bridge line BRL_H and vertical bridge line BRL_V through the contact hole.

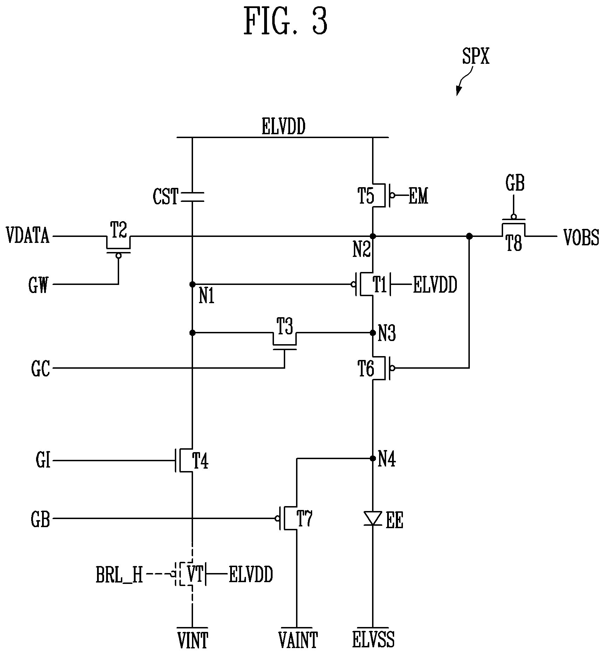

FIG. 3 is a circuit diagram illustrating an example of the sub-pixel SPX of the display device DD of FIG. 1.

Referring to FIG. 3, the sub-pixel SPX may include a first transistor T1 (i.e., a driving transistor) including a control electrode (or a gate electrode) connected to a first node N1, a first electrode connected to a second node N2, a second electrode connected to a third node N3, and a back gate electrode that receives a first power supply voltage ELVDD (i.e., a high power supply voltage), a second transistor T2 (i.e., a write transistor) including a control electrode that receives a write gate signal GW, a first electrode that receives a data voltage VDATA, and a second electrode that is connected to the second node N2, a third transistor T3 (i.e., a compensation transistor) including a control electrode that receives a compensation gate signal GC, a first electrode connected to the third node N3, and a second electrode connected to the first node N1, a fourth transistor T4 (i.e., an initialization transistor) including a control electrode that receives an initialization gate signal GI, a first electrode that receives a first initialization voltage VINT, and a second electrode connected to the first node N1, a fifth transistor T5 (i.e., a first light-emitting transistor) including a control electrode that receives an emission signal EM, a first electrode that receives the first power supply voltage ELVDD, and a second electrode connected to the second node N2, a sixth transistor T6 (i.e., a second light-emitting transistor) including a control electrode connected to the second node N2, a first electrode connected to the third node N3, and a second electrode connected to a fourth node N4, a seventh transistor T7 (i.e., an anode initialization transistor) including a control electrode that receives a bias gate signal GB, a first electrode that receives a second initialization voltage VAINT, and a second electrode connected to the fourth node N4, an eighth transistor T8 (i.e., a bias transistor) including a control electrode that receives the bias gate signal GB, a first electrode that receives a bias voltage VOBS, and a second electrode connected to the second node N2, a storage capacitor CST including a first electrode that receives the first power supply voltage ELVDD and a second electrode coupled to the first node N1, and a light-emitting element EE including a first electrode (i.e., an anode electrode) coupled to the fourth node N4 and a second electrode that receives a second power supply voltage ELVSS (for example, a low power supply voltage). However, embodiments are not limited to the structure of the sub-pixel SPX.

The first, second, and fifth to eighth transistors T1, T2, and T5 to T8 may be implemented as p-channel metal oxide semiconductor (PMOS) transistors. For example, the first, second, and fifth to eighth transistors T1, T2, and T5 to T8 may be P-type silicon thin film transistors. However, embodiments are not limited thereto. According to an embodiment, at least one of the first, second, and fifth to eighth transistors may be implemented as an n-channel metal oxide semiconductor (NMOS) transistor.

The third and fourth transistors T3 and T4 may be implemented as NMOS transistors. However, embodiments are not limited thereto. According to an embodiment, at least one of the third and fourth transistors T3 and T4 may be implemented as a PMOS transistor.

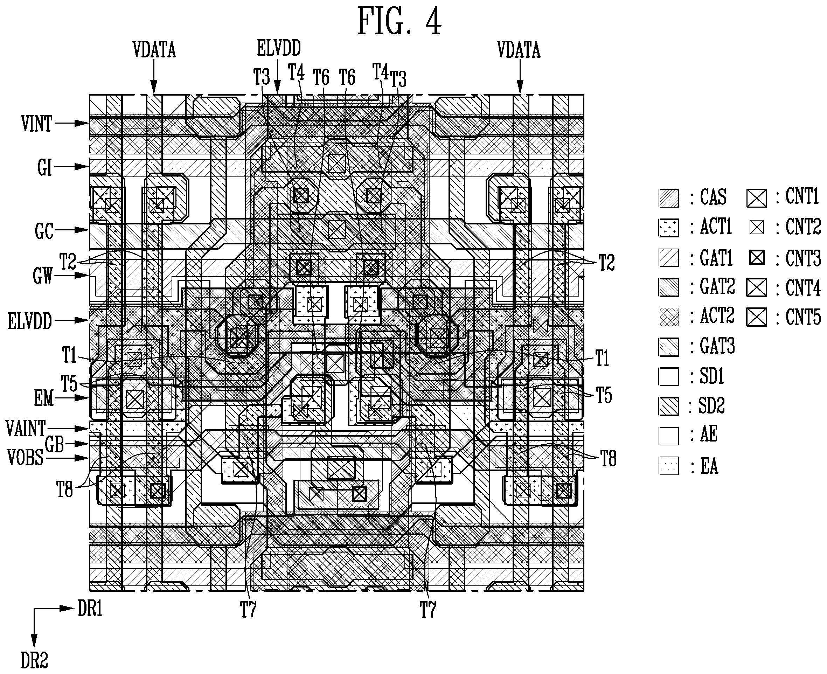

In an embodiment, the third and fourth transistors T3 and T4 may be N-type oxide thin film transistors. The oxide thin film transistor may be a thin film transistor in which an active pattern (e.g., a second active pattern ACT2, refer to FIG. 4) includes an oxide. For example, the oxide thin film transistor may include a metal material such as Indium-Gallium-Zinc Oxide (IGZO). However, this is mere an example, and N-type transistors are not limited thereto. For example, the active pattern included in the N-type transistor (e.g., the second active pattern ACT2, refer to FIG. 4) may include an inorganic semiconductor (e.g., amorphous silicon, poly silicon), an organic semiconductor, or the like. The silicon thin film transistor may be a low temperature poly-silicon (LTPS) thin film transistor in which an active pattern (e.g., a first active pattern ACT1, refer to FIG. 4) includes amorphous silicon, poly silicon, or the like.

A detailed description of an unintentionally formed transistor VT will be described later.

FIG. 4 is an arrangement diagram illustrating an example of the display panel DP of FIG. 1.

Referring to FIG. 4, the display panel DP (refer to FIG. 1) may include a lower conductive layer CAS, the first active layer ACT1, a first gate conductive layer GAT1, a second gate conductive layer GAT2, the second active layer ACT2, a third gate conductive layer GAT3, a first upper conductive layer SD1, a second upper conductive layer SD2, and an anode electrode AE.

The lower conductive layer CAS, the first to third gate conductive layers GAT1 to GAT3, and the first and second upper conductive layers SD1 and SD2 may include a metal, an alloy, a conductive metal oxide, a transparent conductive material, or the like. The materials mentioned above may be used alone or in combination with one another.

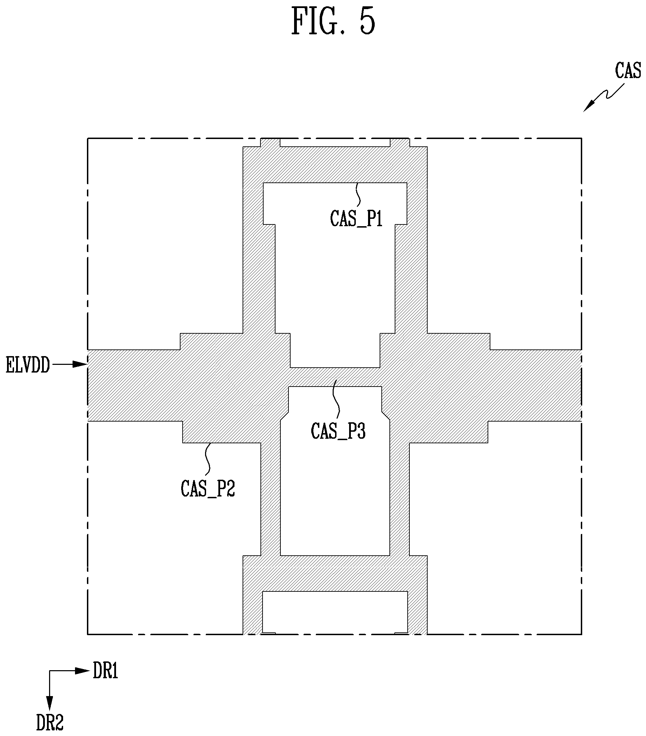

FIG. 5 is an arrangement diagram illustrating the lower conductive layer CAS of FIG. 4.

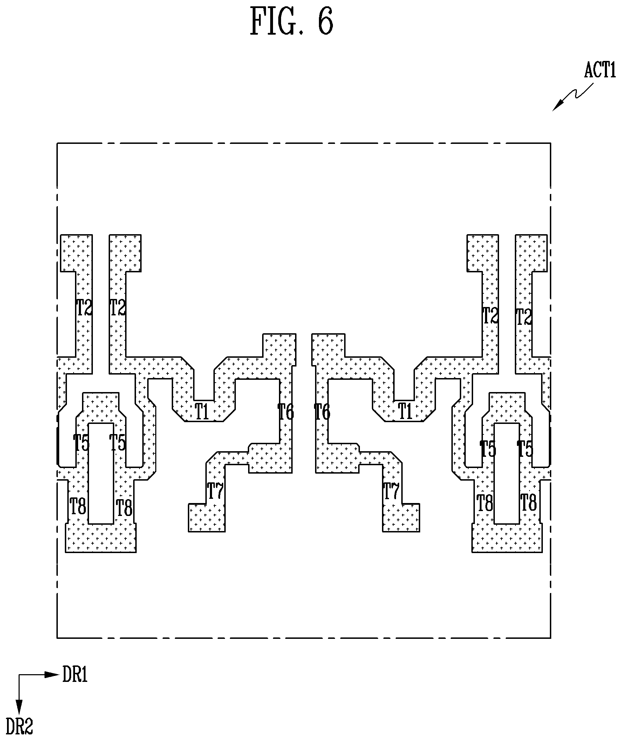

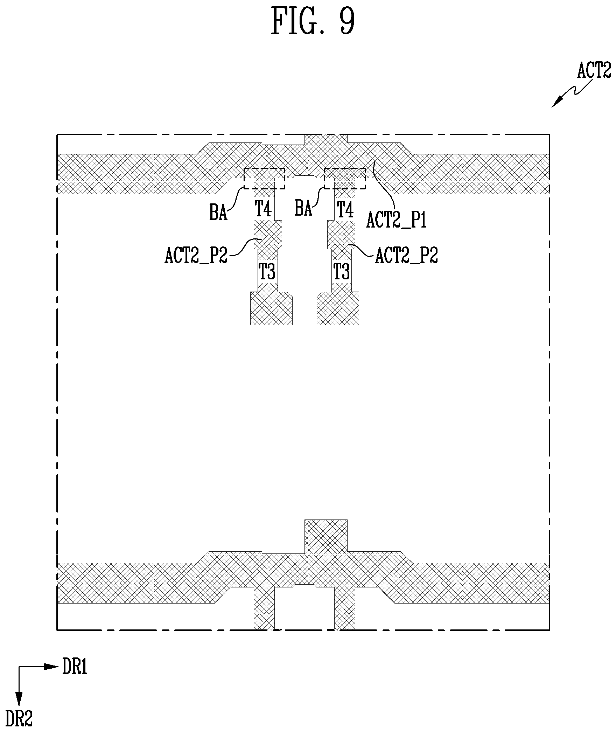

Referring to FIG. 5, the first power supply voltage ELVDD may be applied to the lower conductive layer CAS. The lower conductive layer CAS may include a first portion CAS_P1 overlapping with a first portion ACT2_P1 of the second active layer ACT2 (refer to FIG. 9), a second portion CAS_ P2 overlapping with a portion of the first active layer ACT1 (refer to FIG. 6), and a third portion CAS_ P3 connecting the second portions CAS_P2 of the lower conductive layers CAS.

FIG. 6 is an arrangement diagram illustrating the first active layer ACT1 of FIG. 4.

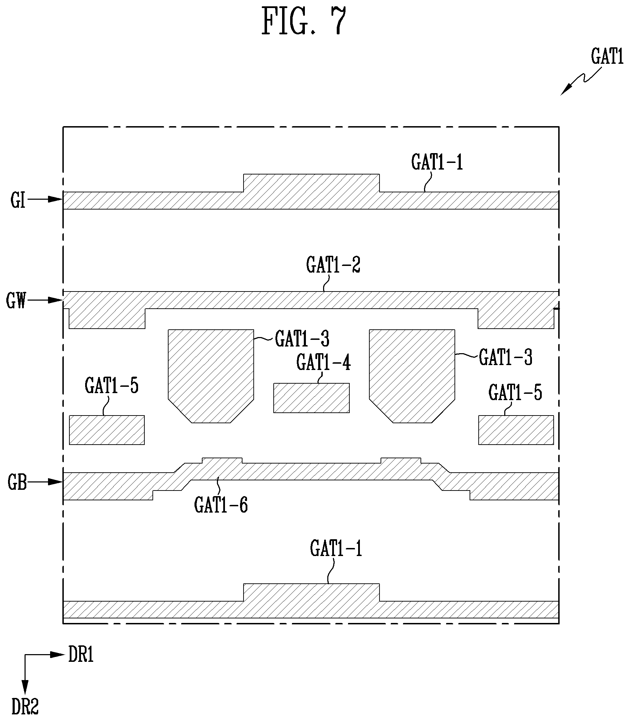

Referring to FIG. 6, the first active layer ACT1 may be disposed over the lower conductive layer CAS (refer to FIG. 5). A region overlapping with the first gate conductive layer GAT1 (refer to FIG. 7) of the first active layer ACT1 is a semiconductor pattern that is not doped with impurities, and may be an intrinsic semiconductor. In addition, a region overlapping with the first gate conductive layer GAT1 (refer to FIG. 7) of the first active layer ACT1 may form a channel region of the first, second, and fifth to eighth transistors T1, T2, and T5 to T8. A region of the first active layer ACT1 that does not overlap with the first gate conductive layer GAT1 (refer to FIG. 7) is a semiconductor pattern doped with impurities, and the first, second, and fifth to eighth transistors T1, T2, and T5 to T8 may be connected to each other.

Referring to FIGS. 5 and 6, the second portion CAS_P2 of the lower conductive layer CAS may overlap a portion of the first active layer ACT1 forming the channel region of the first transistor T1 to form the back gate electrode of the first transistor T1.

FIG. 7 is an arrangement diagram illustrating the first gate conductive layer GAT1 of FIG. 4.

Referring to FIG. 7, the first gate conductive layer GAT1 may be disposed over the first active layer ACT1 (refer to FIG. 6). The first gate conductive layer GAT1 may include 1-1st to 1-6th gate conductive patterns GAT1-1 to GAT1-6.

The 1-1st gate conductive pattern GAT1-1 may form a back gate electrode of the fourth transistor T4 (refer to FIG. 9). The initialization gate signal GI may be applied to the 1-1st gate conductive pattern GAT1-1.

The 1-2nd gate conductive pattern GAT1-2 may form a control electrode of the second transistor T2 (refer to FIG. 6). The write gate signal GW may be applied to the 1-2 gate conductive pattern GAT1-2.

The 1-3rd gate conductive pattern GAT1-3 may form the second electrode of the storage capacitor CST (refer to FIG. 3). The 1-4th gate conductive pattern GAT1-4 may form the control electrode of the sixth transistor T6 (refer to FIG. 6). The 1-5th gate conductive pattern GAT1-5 may form the control electrode of the fifth transistor T5 (refer to FIG. 6).

The 1-6th gate conductive pattern GAT1-6 may form the control electrode of each of the seventh and eighth transistors T7 and T8. The bias gate signal GB may be applied to the 1-6 gate conductive pattern GAT1-6.

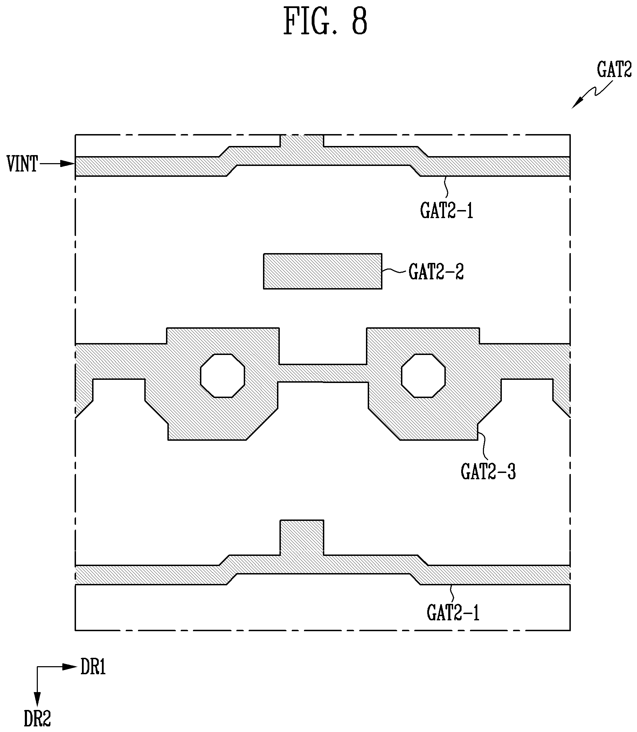

FIG. 8 is an arrangement diagram illustrating the second gate conductive layer GAT2 of FIG. 4.

Referring to FIG. 8, the second gate conductive layer GAT2 may be disposed over the first gate conductive layer GAT1 (refer to FIG. 7). The second gate conductive layer GAT2 may include 2-1st to 2-3rd gate conductive patterns GAT2-1 to GAT2-3.

The first initialization voltage VINT may be applied to the 2-1st gate conductive pattern GAT2-1. The 2-2nd gate conductive pattern GAT2-2 may form a back gate electrode of the third transistor T3 (refer to FIG. 9). The 2-3rd gate conductive pattern GAT2-3 may form the first electrode of the storage capacitor CST (refer to FIG. 3).

FIG. 9 is an arrangement diagram illustrating the second active layer ACT2 of FIG. 4.

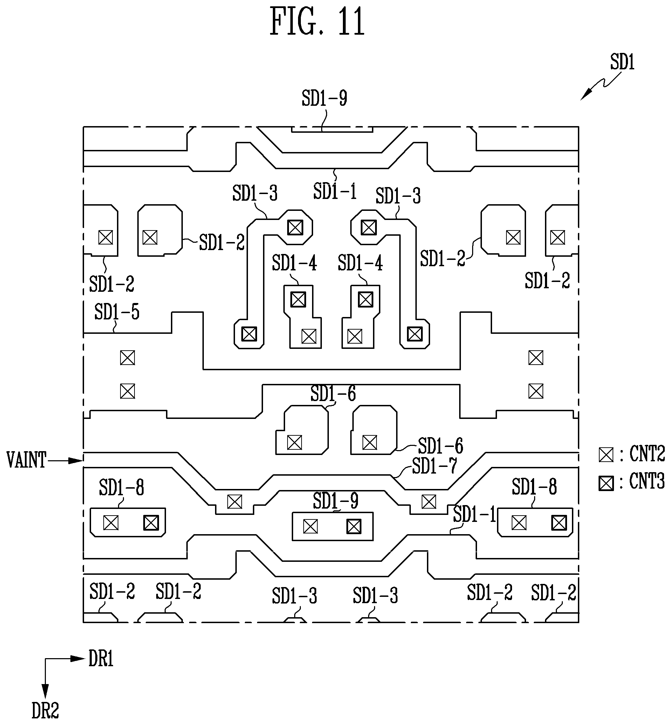

Referring to FIG. 9, the second active layer ACT2 may be disposed over the second gate conductive layer GAT2 (refer to FIG. 8). The first portion ACT2_P1 of the second active layer ACT2 may form the first electrode of the fourth transistor T4. The first initialization voltage VINT may be applied to the first portion ACT2_P1 of the second active layer ACT2 through the 2-1st gate conductive pattern GAT2-1 (refer to FIG. 8) and a 1-9th upper conductive pattern SD1-9 (refer to FIG. 11).

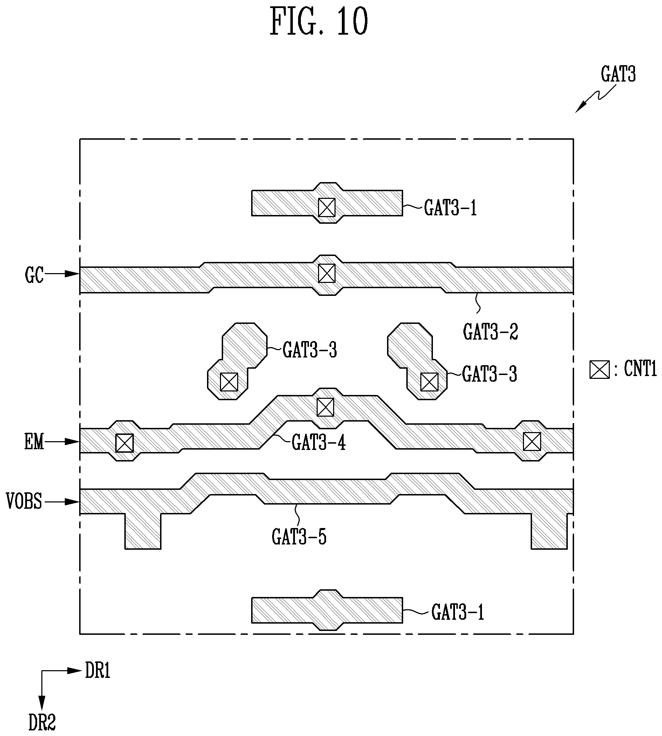

The second portion ACT2_P2 of the second active layer ACT2 may form a channel region of each of the third and fourth transistors T3 and T4. For example, a portion of the second active layer ACT2 overlapping the third gate conductive layer GAT3 (refer to FIG. 10) may form the channel region of the third transistor T3 or the fourth transistor T4.

Referring to FIGS. 3, 5, and 9, impurities may not be appropriately doped on a portion of the second active layer ACT2 that does not overlap with the third gate conductive layer GAT3 (refer to FIG. 10) due to a defect in the process. In this case, the transistor VT may be formed unintentionally. The transistor VT may include a control electrode that receives the signal of the horizontal bridge line BRL_H, a first electrode that receives the first initialization voltage VINT, and a second electrode connected to the fourth transistor T4. When the transistor VT is turned off, a stain may be generated or displayed on the display panel DP (refer to FIG. 1). However, as the first portion CAS_P1 of the lower conductive layer CAS overlaps a boundary area BA between the first portion ACT2_P1 of the second active layer ACT2 and the second portion ACT2_P2 of the second active layers ACT2, the first portion CAS_P1 of the lower conductive layer CAS may form a back gate electrode of the transistor VT. in this case, when the first power supply voltage ELVDD is applied to the back gate electrode of the transistor VT, the transistor VT may be turned on regardless of the signal of the horizontal bridge line BRL_H, and the stain may be minimized.

In this embodiment, the lower conductive layer CAS forms the back gate electrode of the transistor VT as an example, but embodiments are not limited thereto, and a conductive layer disposed under the second active layer ACT2 is sufficient to form the back gate electrode.

FIG. 10 is an arrangement diagram illustrating the third gate conductive layer GAT3 of FIG. 4.

Referring to FIG. 10, the third gate conductive layer GAT3 may be disposed over the second active layer ACT2 (refer to FIG. 9). The third gate conductive layer GAT3 may include 3-1st to 3-5th gate conductive patterns GAT3-1 to GAT3-5.

The 3-1st gate conductive pattern GAT3-1 may form a control electrode of the fourth transistor T4. The compensation gate signal GC may be applied to the 3-2nd gate conductive pattern GAT3-2, and the 3-2 gate conductive pattern GAT3-3 may form a control electrode of the third transistor T3.

The 3-3rd gate conductive pattern GAT3-3 may be connected to the 1-3rd gate conductive pattern GAT1-3 (refer to FIG. 7) through a first contact hole CNT1. In addition, the second portion ACT2_P2 (refer to FIG. 9) of the second active layer ACT2 (refer to FIG.9) may be connected to the 3-3rd gate conductive pattern GAT3-3 through a 1-3rd upper conductive pattern SD1-3 (refer to FIG. 11) to be described later.

The emission signal EM may be applied to the 3-4th gate conductive pattern GAT3-4, and the 3-4th gate conductive pattern GAT3-4 may be connected to the 1-4th and 1-5th conductive patterns GAT1-4 and GAT1-5 through the first contact hole CNT1.

The bias voltage VOBS may be applied to the 3-5th gate conductive pattern GAT3-5. The 3-5th gate conductive pattern GAT3-5 may be connected to the eight transistor T8 (refer to FIG. 6) through a 1-8th upper conductive pattern SD1-8 to be described later.

FIG. 11 is an arrangement diagram illustrating the first upper conductive layer SD1 of FIG. 4.

Referring to FIG. 11, the first upper conductive layer SD1 may be disposed over the third gate conductive layer GAT3 (refer to FIG. 10). The first upper conductive layer SD1 may include first to ninth upper conductive patterns SD1-1 to SD1-9.

The 1-1st upper conductive pattern SD1-1 may form the horizontal bridge line BRL_H. The 1-1st upper conductive pattern SD1-1 may overlap the first portion ACT2_P1 of the second active layer ACT2 (refer to FIG. 9).

The 1-2nd upper conductive pattern SD1-2 may be connected to the second transistor T2 (refer to FIG. 6) through a second contact hole CNT2. The 1-3rd upper conductive pattern SD1-3 may be connected to the second portion ACT2_P2 of the second active layer ACT2 (refer to FIG. 9) and the 3-3rd gate conductive pattern GAT3-3 through third contact holes CNT3.

The 1-4th upper conductive pattern SD1-4 may be connected to the first active layer ACT1 (refer to FIG. 6) through the second contact hole CNT2, and may be connected to the second portion ACT2_P2 (refer to FIG. 9) of the second active layer ACT2 (refer to FIG, 9) through the third contact hole CNT3. Accordingly, the 1-4th upper conductive pattern SD1-4 may connect the first transistor T1 (refer to FIG. 6) and the third transistor T3 (refer to FIG. 9).

The 1-5th conductive pattern SD1-5 may be connected to the first active layer ACT1 (refer to FIG. 6) and the 2-3rd gate conductive pattern GAT2-3 (refer to FIG. 8) through the second contact hole CNT2. The 1-6th conductive pattern SD1-6 may be connected to the first active layer ACT1 (refer to FIG. 6) through the second contact hole CNT2. The second initialization voltage VAINT may be applied to the 1-7th upper conductive pattern SD1-7, and the 1-7th upper conductive pattern SD1-7 may be connected to the first active layer ACT1 through the second contact hole CNT2. The 1-9th conductive pattern SD1-9 may be connected to the 2-1th gate conductive pattern GAT2-1 (refer to FIG. 8) through the second contact hole CNT2, and may be connected to the first portion ACT2_P1 (refer to FIG. 9) of the second active layer ACT2 (refer to FIG.9) through the third contact hole CNT3.

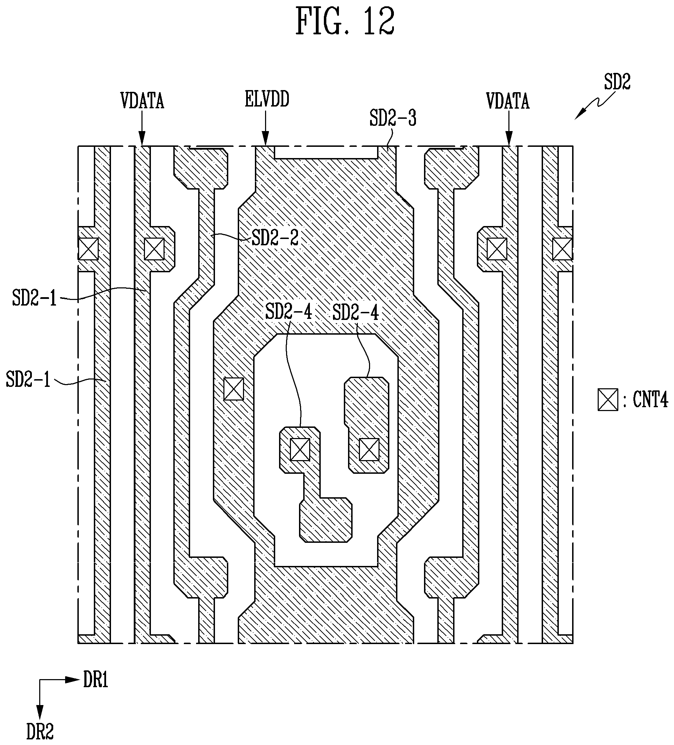

FIG. 12 is an arrangement diagram illustrating the second upper conductive layer SD2 of FIG. 4.

Referring to FIG. 12, the second upper conductive layer SD2 may be disposed over the first upper conductive layer SD1 (refer to FIG. 11). The second upper conductive layer SD2 may include 2-1st to 2-4th upper conductive patterns SD2-1 to SD2-4.

The data voltage VDATA may be applied to the 2-1st upper conductive pattern SD2-1, and the 2-1st upper conductive pattern SD2-1 may be connected to the first active layer ACT1 (refer to FIG. 6) through a fourth contact hole CNT4. That is, the 2-1st upper conductive pattern SD2-1 may form a data line.

The 2-2nd upper conductive pattern SD2-2 may form the vertical bridge line BRL_V. The first power supply voltage ELVDD may be applied to the 2-3rd upper conductive pattern SD2-3, and the 2-3rd upper conductive pattern SD2-3 may be connected to the 1-5st upper conductive pattern SD1-5 (refer to FIG. 11) through the fourth contact hole CNT4. The 2-4st upper conductive pattern SD2-4 may be connected to the 1-6st upper conductive pattern SD1-6 (refer to FIG. 11) through the fourth contact hole CNT4.

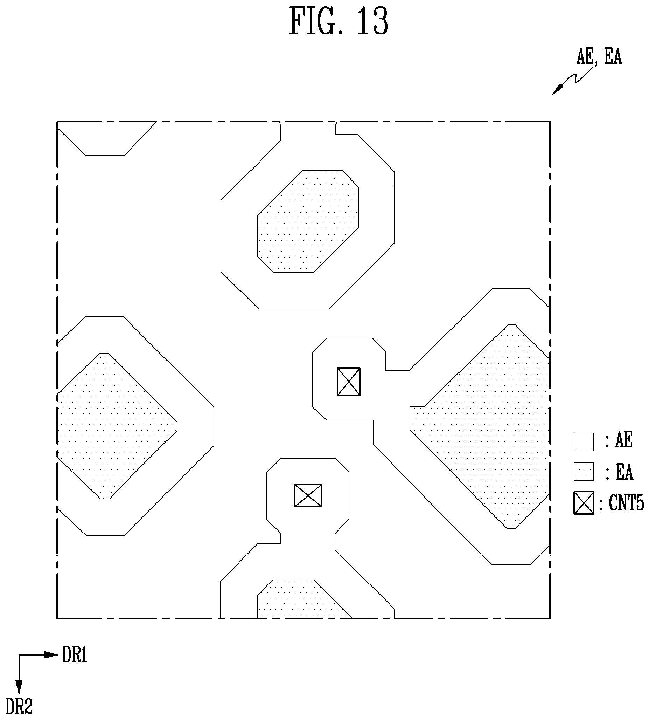

FIG. 13 is an arrangement diagram illustrating the anode electrode AE of FIG. 4.

Referring to FIG. 13, the anode electrode AE may be disposed over the second upper conductive layer SD2 (refer to FIG. 12). The anode electrode AE may be connected to the 2-4th upper conductive pattern SD2-4 (refer to FIG. 12) through a fifth contact hole CNT5. The light-emitting area EA may be disposed over the anode electrode AE. A light-emitting structure of the light-emitting element EE (refer to FIG. 3) may be disposed in the light-emitting area EA.

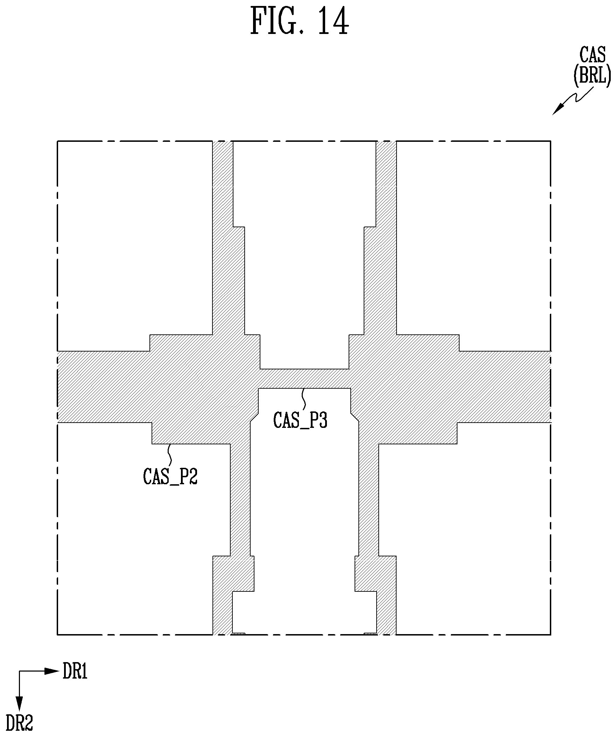

FIG. 14 is an arrangement diagram illustrating a lower conductive layer of a display device according to embodiments.

Since the display panel of the display device according to the present embodiments is substantially the same as the configuration of the display panel DP of FIG. 4 except for the form of the lower conductive layer CAS in a portion of the second display area DA2 where the bridge line BRL is not disposed, the same reference numerals and reference symbols are used for the same or similar components, and duplicate descriptions are omitted.

Referring to FIGS. 2 and 14, the bridge line BRL may not be disposed in the portion of the second display area DA2 of the display panel DP. Since the transistor VT (refer to FIG. 3) is not formed unintentionally by the bridge line BRL in the portion of the second display area DA2, the first part of the lower conductive layer CAS (refer to the first portion CAS_P1, FIG. 5) may not be required. In this case, the lower conductive layer CAS having the shape of FIG. 5 may be disposed in a portion of the display area DA in which the bridge line BRL is disposed.

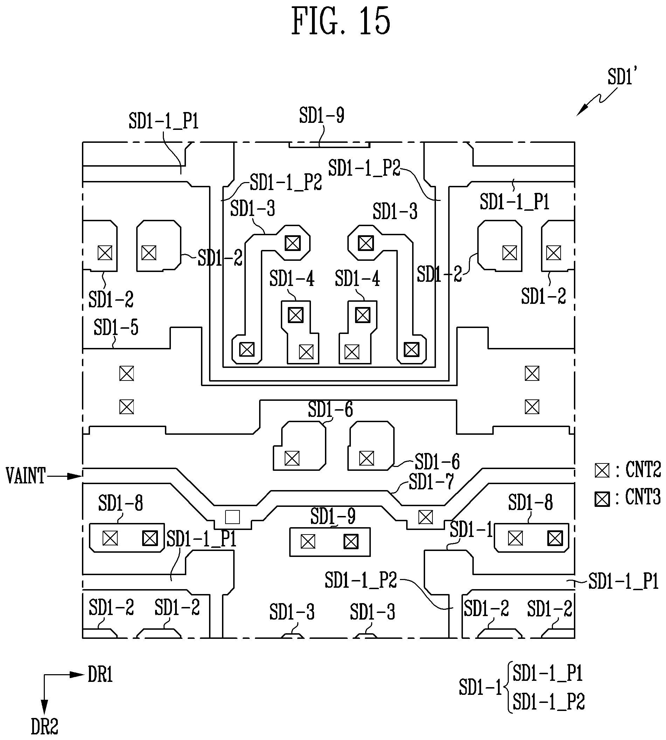

FIG. 15 is an arrangement diagram illustrating a first upper conductive layer of a display device according to embodiments.

Since the display panel of the display device according to the present embodiments is substantially the same as the configuration of the display panel DP of FIG. 4 except for the 1-1st upper conductive pattern SD1-1, the same reference numerals and reference symbols are used for the same or similar components, and redundant descriptions are omitted.

Referring to FIGS. 9 and 15, the 1-1st upper conductive pattern SD1-1 may not overlap the boundary area BA between the first portion ACT2_P1 of the second active layer ACT2 and the second portion ACT2_P2 of the second active layers ACT2. For example, the 1-1st upper conductive pattern SD1-1 may include first portions SD1-1_P1 extending in the first direction DR1 and second portions SD1-1_P2 extending in the second direction DR2 from the first portions SD1-1_P1. Each of the second portions SD1-1_P2 of the 1-1st upper conductive pattern SD1-1 may bypass the boundary area BA between the first portion ACT2_P1 of the second active layer ACT2 and the second portion ACT2_P2 of the second active layer ACT2 to connect the first portions SD1-1_P1 of the 1-1st upper conductive pattern SD1-1.

In this case, since the transistor VT (refer to FIG. 3) is not formed unintentionally by the bridge line BRL, the first portion CAS_P1 (refer to FIG. 5) of the lower conductive layer CAS (refer to FIG.5) may not be required. Therefore, the lower conductive layer CAS (refer to FIG. 14) of the display panel DP (refer to FIG. 1) according to the present embodiment may have substantially the same shape as that of FIG. 14.

The display device according to embodiments may be applied to various electronic devices. The electronic device according to an embodiment includes the above-described display device, and may further include a module or device having an additional function other than the display device.

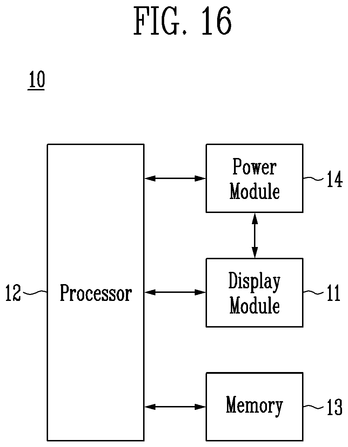

FIG. 16 is a block diagram of an electronic device 10 according to an embodiment. Referring to FIG. 16, the electronic device 10 according to an embodiment may include a display module 11, a processor 12, a memory 13, and a power module 14.

The processor 12 may include at least one of a central processing unit (CPU), an application processor (AP), a graphics processing unit (GPU), a communication processor (CP), an image signal processor (ISP), and a controller.

The memory 13 may store data information necessary for the operation of the processor 12 or the display module 11. When the processor 12 executes the application stored in the memory 13, the image data signal and/or the input control signal are transmitted to the display module 11, and the display module 11 may process the received signal and output the image information through the display screen.

The power module 14 may include a power supply module such as a power adapter or a battery device, and a power conversion module that converts power supplied by the power supply module to generate power necessary for the operation of the electronic device 10.

At least one of the above-described components of the electronic device 10 may be included in the display device according to the above-described embodiments. In addition, some of the individual modules that are functionally included in one module may be included in the display device, and others may be provided separately from the display device. For example, the display device includes the display module 11, and the processor 12, the memory 13, and the power module 14 may be provided in the form of other devices in the electronic device 10 other than the display device.

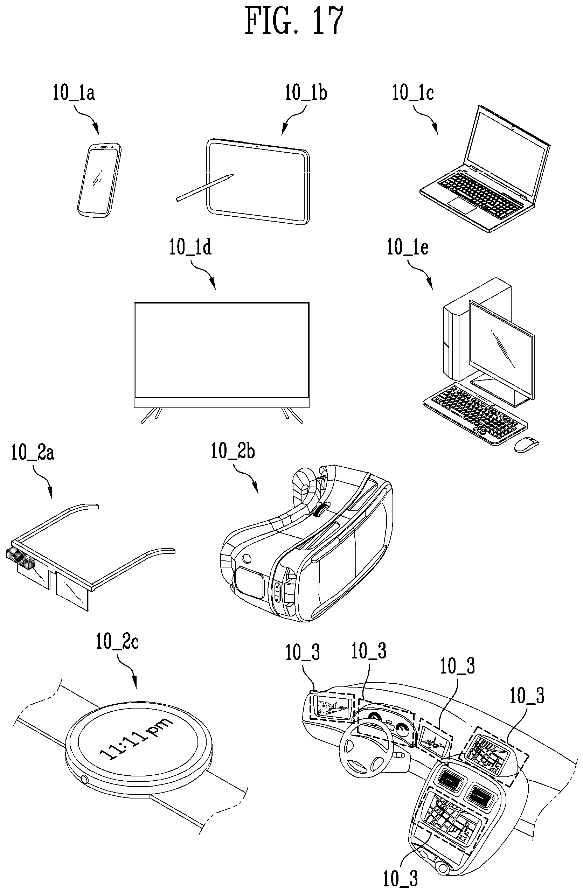

FIG. 17 is a schematic diagram of an electronic device according to various embodiments.

Referring to FIG. 17, various electronic devices to which the display device according to embodiments is applied may include not only an electronic device for displaying an image such as a smartphone 10_1a, a tablet PC 10_1b, a laptop 10_1c, a TV 10_1d, and a desk monitor 10_1e, but also a wearable electronic device including a display module such as smart glasses 10_2a, a head mounted display 10_2b, and a smart watch 10_2c, an electronic device for a vehicle 10_3 including a display module, such as a CID (Center Information Display) and a room mirror display, disposed over an instrument panel, a center fascia, and a dashboard of a vehicle, or the like.

As discussed, embodiments may provide a display device comprising: a display panel including a sub-pixel; and a driver arranged to control the display panel, wherein the display panel includes: a first conductive layer including a first portion overlapping a first portion of a first active layer; the first active layer disposed over the first conductive layer, an initialization voltage being applied to the first portion of the first active layer, a second portion of the first active layer forming a channel region of at least one transistor of the sub-pixel; a second conductive layer disposed over the first active layer and including a first conductive pattern forming a control electrode of the at least one transistor; and a third conductive layer disposed over the second conductive layer and including a second conductive pattern forming a horizontal bridge line and overlapping the first portion of the first active layer.

As written in this way, the first conductive layer may correspond to "lower conductive layer CAS", the first active layer may correspond to the "second active layer ACT2", the second conductive layer may correspond to the "third gate conductive layer GAT3", and the third conductive layer may correspond to the "first upper conductive layer SD1" as discussed above.

The display device may comprise a suitable voltage source to provide the initialization voltage to the first portion of the first active layer. Hence, the first portion of the first active layer may be connected to this voltage source.

Embodiments may provide a display device comprising: a display panel including a sub-pixel; and a driver arranged to control the display panel; wherein the display panel includes: a first active layer including a first portion arranged to receive an initialization voltage and a second portion forming a channel region of at least one transistor of the sub-pixel; a second conductive layer disposed over the first active layer and including a first conductive pattern forming a control electrode of the at least one transistor; and a third conductive layer disposed over the second conductive layer and including a second conductive pattern forming a horizontal bridge line, wherein the second conductive pattern does not overlap a boundary region between the first portion of the first active layer and the second portion of the first active layer.

Embodiments may provide an electronic device including a display device as set out in any of the above mentioned embodiments.

Although specific embodiments and application examples have been described herein, it is intended to provide a more general understanding of the inventive concept, and the inventive concept is not limited to the above embodiments, and various modifications and variations can be made by those skilled in the art from this description.

Therefore, the inventive concept should not be limited to the embodiments described, and all equivalent or equivalent modifications of the claims as well as the claims described below fall within the scope of the inventive concept.

A display device and an electronic device including the same according to the embodiments of the inventive concept, even if a transistor is formed unintentionally because impurities are not appropriately doped in an active layer, the transistor can be turned on by forming a first conductive layer under the transistor. Accordingly, unintentionally formed stains due to the transistors can be minimized.

Although specific embodiments and applications have been described herein, other embodiments and modifications may be derived from the above description. Accordingly, the inventive concept is not limited to such embodiments, but rather to the broader scope of the presented claims and various obvious modifications and equivalent arrangements.

### Industrial Availability

Embodiments may be applied to a display device and an electronic device including the same. For example, embodiments may be applied to a digital TV, a 3D TV, a mobile phone, a smart phone, a tablet computer, a VR device, a PC, a home electronic device, a notebook computer, a PDA, a PMP, a digital camera, a music player, a portable game console, navigation, or the like.

While the embodiments have been described above, it will be understood that those skilled in the art can make various modifications and changes to embodiments without departing from the scope of the inventive concept as set forth in the following claims.

## Claims

1. A display device comprising:
a display panel including a sub-pixel; and
a driver arranged to control the display panel,
wherein the display panel includes:
a first conductive layer including a first portion overlapping a first portion of a first active layer;
the first active layer disposed over the first conductive layer, an initialization voltage being applied to the first portion of the first active layer, a second portion of the first active layer forming a channel region of at least one transistor of the sub-pixel;
a second conductive layer disposed over the first active layer and including a first conductive pattern forming a control electrode of the at least one transistor; and
a third conductive layer disposed over the second conductive layer and including a second conductive pattern forming a horizontal bridge line and overlapping the first portion of the first active layer.

2. The display device according to claim 1, wherein a first power supply voltage is applied to the first conductive layer.

3. The display device according to claim 2, wherein the display panel further includes a second active layer including a portion forming a channel region of a driving transistor of the sub-pixel, and
wherein the first conductive layer includes a second portion overlapping the portion of the second active layer.

4. The display device according to any one of claims 1 to 3, wherein the first portion of the first active layer does not overlap the first conductive pattern.

5. The display device according to any one of claims 1 to 4, wherein the second portion of the first active layer overlaps the first conductive pattern.

6. The display device according to any one of claims 1 to 5, wherein the display panel further includes a display area including sub-pixels including the sub-pixel and a non-display area,
wherein the display area includes a first display area and a second display area,
wherein at least one of the sub-pixels is in the first display area and is electrically connected to the driver through a bridge line including a data line and the horizontal bridge line, and
wherein at least one of the sub-pixels is in the second display area and is connected to the driver through the data line.

7. The display device according to claim 6, wherein the bridge line is connected to the data line via the display area.

8. The display device according to claim 6 or 7, wherein the bridge line further includes a vertical bridge line extending in one direction, and
wherein the horizontal bridge line extends in a direction intersecting the one direction.

9. The display device according to claim 8, wherein the display panel includes a fourth conductive layer disposed on the third conductive layer and including a conductive pattern forming the vertical bridge line.

10. The display device according to any one of claims 1 to 9,
wherein the sub-pixel includes:
a driving transistor;
a storage capacitor connected to a control electrode of the driving transistor; and
an initialization transistor arranged to provide the initialization voltage to the storage capacitor in response to an initialization gate signal, and
wherein the second portion of the first active layer forms a channel region of the initialization transistor.

11. The display device according to any one of claims 1 to 10, wherein the display panel further includes:
a second active layer disposed over the first conductive layer and disposed under the first active layer;
a fifth conductive layer disposed over the second active layer and disposed under the first active layer; and
a sixth conductive layer disposed over the fifth conductive layer and disposed under the first active layer.

12. A display device comprising:
a display panel including a sub-pixel; and
a driver arranged to control the display panel;
wherein the display panel includes:
a first active layer including a first portion arranged to receive an initialization voltage and a second portion forming a channel region of at least one transistor of the sub-pixel;
a second conductive layer disposed over the first active layer and including a first conductive pattern forming a control electrode of the at least one transistor; and
a third conductive layer disposed over the second conductive layer and including a second conductive pattern forming a horizontal bridge line, wherein the second conductive pattern does not overlap a boundary region between the first portion of the first active layer and the second portion of the first active layer.

13. The display device according to claim 12, wherein the second conductive pattern includes first portions extending in one direction and second portions extending from the first portions in a direction intersecting the one direction to connect the first portions; and/or
wherein the first portion of the first active layer does not overlap the first conductive pattern; and/or
wherein the second portion of the first active layer overlaps the first conductive pattern.

14. The display device according to claim 12 or 13, wherein the display panel further includes a display area including sub-pixels including the sub-pixel and a non-display area,
wherein the display area includes a first display area and a second display area,
wherein at least one of the sub-pixels is in the first display area and is electrically connected to the driver through a data line and a bridge line including the horizontal bridge line, and
wherein at least one of the sub-pixels is in the second display area and is connected to the driver through the data line;
optionally wherein the bridge line is connected to the data line via the display area;
further optionally wherein the bridge line further includes a vertical bridge line extending in one direction, and wherein the second conductive pattern includes first portions extending in a direction intersecting the one direction;
still further optionally wherein the display panel further includes a fourth conductive layer disposed over the third conductive layer and including a conductive pattern forming the vertical bridge line.

15. An electronic device comprising:
a processor to provide input image data; and
a display device to display an image based on the input image data,
wherein the display device is according to any one of claims 1 to 14.
